Europäisches Patentamt

**European Patent Office**

Office européen des brevets

(11) Veröffentlichungsnummer: **0 053 749
B1**

(12) **EUROPÄISCHE PATENTSCHRIFT**

(45) Veröffentlichungstag der Patentschrift:
03.07.85

(21) Anmeldenummer: 81109831.8

(22) Anmeldetag: 23.11.81

(51) Int. Cl.⁴: **C 08 G 18/67**, G 03 F 7/10,
G 03 C 1/68, C 08 F 20/36,
C 09 D 3/80, D 06 M 15/564

(54) Strahlenhärtbare urethangruppenhaltige Acrylsäureester, Verfahren zu ihrer Herstellung und ihre Verwendung.

(30) Priorität: 04.12.80 DE 3045788

(43) Veröffentlichungstag der Anmeldung:
16.06.82 Patentblatt 82/24

(45) Bekanntmachung des Hinweises auf die Patenterteilung:
03.07.85 Patentblatt 85/27

(84) Benannte Vertragsstaaten:
AT DE FR GB IT NL SE

(56) Entgegenhaltungen:
DE - A - 2 115 373
DE - A - 2 264 460
FR - A - 2 277 863

**Die Akte enthält technische Angaben, die nach dem Eingang der Anmeldung eingereicht wurden und die nicht in dieser Patentschrift enthalten sind.**

(73) Patentinhaber: BAYER AG, Konzernverwaltung RP
Patentabteilung, D-5090 Leverkusen 1 Bayerwerk (DE)

(72) Erfinder: **Neuhaus, Karl-Friedrich, Dr.,
Bodelschwinghstrasse 14, D-4150 Krefeld 1 (DE)**
Erfinder: **Perrey, Hermann, Dr., Auf der Rheinaue 8,
D-4150 Krefeld 11 (DE)**
Erfinder: **Fuhr, Karl, Dr., Kruellsdyk 55,
D-4150 Krefeld 1 (DE)**
Erfinder: **Freier, Hans-Joachim, Dr.,
Campendonckstrasse 5, D-4150 Krefeld (DE)**
Erfinder: **Bendszus, Otto, Breite Strasse 92,
D-4150 Krefeld (DE)**

# Beschreibung

Die Erfindung betrifft strahlenhärtbare urethangruppenhaltige Acrylsäureester, ein Verfahren zu ihrer Herstellung und ihre Verwendung als strahlenhärtbare Überzugsmassen.

Urethangruppenhaltige Acrylharze, die durch Strahlen gehärtet werden, sind allgemein bekannt. Sie werden als hochreaktive Bindemittel mit guten chemischen und mechanischen Eigenschaften beschrieben und finden deshalb eine breite Anwendung als strahlenhärtbare Beschichtungsmassen.

Strahlenhärtbare Urethanacrylate, die, wie beispielsweise in der DE-AS 1 644 797, in der britischen Patentschrift 743 514 oder in der US-PS 3 297 745 beschrieben, als Umsetzungsprodukte von präpolymeren Isocyanaten und Hydroxyalkylacrylaten erhalten werden, weisen im allgemeinen eine hochviskose, teils harzartige Konsistenz auf. Um diese Massen in den verarbeitungsfähigen Zustand zu überführen ist die Mitverwendung grosser Mengen von Vinylmononomeren, sogenannter Reaktivverdünner, unerlässlich.

Die Verwendung von Reaktivverdünnern führt jedoch in den meisten Fällen dazu, dass in den applizierbaren Formulierungen das Bindemittel sehr stark verdünnt wird und somit die mittels der Urethanacrylate bewirkten Lackeigenschaften durch die in den Film mit einpolymerisierten Reaktivverdünner nivelliert werden. Naturgemäss wird dieser Effekt besonders deutlich dann beobachtet, wenn das Bindemittel eine hochviskose Konsistenz aufweist. Ferner weisen viele Vinylmonomere einen intensiven Eigengeruch auf, der auch im Polymerisat, wenn auch deutlich vermindert, erhalten bleibt.

Strahlenhärtbare urethangruppenhaltige Acrylate, die ohne oder mit deutlich geringem Anteil an Vinylmonomeren gehärtet werden können, sind vereinzelt aus der Patentliteratur bekannt.

Die DE-AS 2 115 373 beschreibt lichtempfindliche Gemische, die als Reaktionsprodukte einer ungesättigten Carbonsäure einem Polyol und einem organischen Polyisocyanat erhalten werden, wobei das Polyol ausdrücklich mindestens 5 Etherbindungen enthalten muss. Diese Massen weisen zwar aufgrund ihrer Weichsegmente ein günstiges Viskositätsverhalten auf, die daraus durch lichtindizierte Polymerisation erzeugten gehärteten Massen werden als kautschukartige Elastomere zur Herstellung von Druck- und Gummidruckplatten beschrieben, jedoch genügen sie oft nicht den Qualitätsanforderungen, die an einen ausgehärteten Lacküberzug gestellt werden.

Aus der DE-OS 2 064 079 sind photopolymerisierbare Kopiermassen bekannt, die, neben anderen Bestandteilen, als ethylenisch ungesättigte Massen Umsetzungsprodukte von monohydroxylgruppenhaltigen Acrylsäureestern, z.B. Hydroxyethylacrylat, Trimethylolpropandiacrylat u.a., deren OH-Funktion, und ausschliesslich diese, oxalkyliert sein kann, und einem organischen Diisocyanat enthalten. Diese urethanisierten Acrylsäureester werden als hochviskose Produkte beschrieben, deren Applikation auf den vorgesehenen Trägern unter Verwendung von grossen Mengen Lösungsmitteln erfolgt.

Ferner werden in der DE-AS 2 323 373 durch Bestrahlung härtbare Massen beschrieben, die als Umsetzungsprodukte eines mehrfach ungesättigten, gegebenenfalls mit einem organischen Isocyanat modifizierten Esters mit freien Hydroxylgruppen und einem organischen Isocyanat erhalten werden, wobei es erfindungswesentlich ist, dass das gegebenenfalls mit einem organischen Isocyanat modifizierte Veresterungsprodukt auch nicht umgesetzte Hydroxylgruppen enthält, die sich in einer Hydroxylzahl von 15 bis 70 ausdrücken. Die Auslegeschrift lehrt auch, dass die beschriebenen Massen ein Gemisch aus mehrfach ungesättigten Estern, mehrfach ungesättigten Estern mit freien OH-Funktionen und urethangruppenhaltigen mehrfach ungesättigten Estern darstellen und im gehärteten Zustand zu ausserordentlich harten Filmen führen. Derartige Massen sind meist wegen der Sprödigkeit ihrer gehärteten Filme als Überzugsmassen mit den üblichen Qualitätsanforderungen, insbesondere für flexible Substrate, wie z.B. Papier, Kartonage, Leder usw. nicht geeignet.

Der Erfindung lag die Aufgabe zugrunde, neue strahlenhärtbare Beschichtungsmassen zu finden, die bereits ohne Zusatz von Verdünnungsmittel, wie Lösungsmittel und/oder Reaktivverdünner einerseits eine niedrige Eigenviskosität aufweisen und andererseits hochreaktiv sind, eine Härtung in Gegenwart von Luftsauerstoff erlauben und eine hohe Dunkellagerstabilität aufweisen. Darüber hinaus sollten die gehärteten Filme bzw. Überzüge neben einer hohen Kratzfestigkeit gleichzeitig eine gute Elastizität besitzen, um beispielsweise für die Beschichtung von Papier, Kartonage, Kunststoffen, Leder, Holz oder Vlies geeignet zu sein.

Die Aufgabe wurde dadurch gelöst, dass durch die Umsetzung von ethylenisch ungesättigten, Hydroxylgruppen enthaltenden Partialestern, die formal Ester von Acrylsäure oder Methacrylsäure bzw. deren Gemische und einem oxalkylierten mindestens trifunktionellen Alkohol mit einem Oxalkylierungsgrad von 3 bis 4,5 darstellen, mit Polyisocyanaten und gegebenenfalls Hydroxyalkyl(meth)acrylaten niedrig viskose Massen erhalten werden, die neben einer hohen Reaktivität, und einer hohen Dunkellagerstabilität in Gegenwart von Luftsauerstoff gehärtete Überzüge mit ausgezeichneten, praxisgerechten Qualitäten ergeben.

Gegenstand der Erfindung sind demnach strahlenhärtbare Bindemittel aus Umsetzungsprodukten von Polyisocyanaten mit ethylenisch ungesättigten, Hydroxylgruppen enthaltenden Partialestern und gegebenenfalls Hyroxyalkylacrylaten bzw. Hyroxyalkylmethacrylaten, dadurch gekennzeichnet, dass das Umsetzungsprodukt aus in das oligomere Bindemittel eingebauten Einheiten von

A) 1 Grammäquivalent NCO eines Polyisocyanates mit 2–3, vorzugsweise 2 Isocyanatgruppen pro Molekül,

B) 0,4–1,2, vorzugsweise 0,5–1,1 Grammäquivalenten OH eines ethylenisch ungesättigten Partialesters mit einer OH-Zahl (mg KOH pro g Substanz) von 80 bis 150 aus einem oxalkylierten Trimethylolpropan mit einem Oxalkylierungsgrad von 3 bis 4,5 und Acrylsäure oder Methacrylsäure oder deren Mischungen und

C) 0–0,6, vorzugsweise 0–0,5 Grammäquivalenten OH eines Hydroxyalkylacrylates oder Hydroxyalkylmethacrylates mit 2–6, insbesondere 2 C-Atomen in der Alkylgruppe besteht, wobei die Summe der OH-Grammäquivalente aus B und C 1–1,2, vorzugsweise 1–1,1 beträgt.

Unter einem Grammäquivalent NCO wird die Menge einer Verbindung in Gramm verstanden, in der eine Isocyanatgruppe enthalten ist. Entsprechend ist ein Grammäquivalent OH die Menge einer Verbindung in Gramm, in der eine Hydroxylgruppe enthalten ist. Unter dem Oxalkylierungsgrad wird die Anzahl Mole von Alkylenoxid verstanden, die mit einem Mol des Polyols reagiert haben. Als Alkylenoxide kommen Ethylenoxid, Propylenoxid und Butylenoxid, vorzugsweise Ethylenoxid in Frage.

Unter dem Begriff Polyisocyanat werden di- und höher funktionelle Isocyanate verstanden, vorzugsweise di- und trifunktionelle, insbesondere difunktionelle. Beispielsweise seien genannt: 2,4-Toluylendiisocyanat bzw. 2,6-Toluylendiisocyanat sowie deren Gemische, Diphenylmethan-4,4'-diisocynat, Isophorondiisocyanat, Xylylendiisocyanat, Hexamethylendiisocyanat, 3,3'-Dimethyldiphenylmethan-4,4'-diisocyanat, 4,4'-Diisocyanatodicyclohexylmethan, 1,5-Naphthalindiisocyanat, Ethylendiisocyanat, Propylendiisocyanat, Cyclohexyldiisocyanat, Cyclopentadienyldiisocyanat, 3,3'-Dimethyl-4,4'-diisocyanatdiocyclohexylmethan, m-Phenylendiisocyanat, Triphenylmethan-4,4',4''-triisocyanat, Triphenylurethan-Reaktionsprodukte aus 1 Mol Trimethylolpropan und 3 Mol Toluylendiisocyanat, Umsetzungsprodukte aus 3 Mol Hexamethylendiisocyanat und 1 Mol Wasser (Biuret). Besonders bevorzugt sind Toluylendiisocyanate, Isophorondiisocyanat, 4,4'-Diisocyanatodicyclohexylmethan und Hexamethylendiisocyanat.

Die Polyisocyanate können allein oder in Gemischen eingesetzt werden.

Unter Komponente B werden erfindungsgemäss OH-gruppenhaltige, ethylenisch ungesättigte Partialester, die formal Acrylsäureester oder Methacrylsäureester oder Mischungen dieser von oxalkyliertem Trimethylolpropan mit einem Oxalkylierungsgrad von 3 bis 4,5 darstellen, verstanden.

Die Komponente B wird durch Veresterung des oxalkylierten Trimethylolpropans mit Acrylsäure oder Methacrylsäure oder Mischungen dieser, durch Umesterung geeigneter Acrylsäureester oder Methacrylsäureester oder Mischungen dieser mit oxalkyliertem Trimethylolpropan oder durch Umsetzung eines Acrylsäurehalogenids oder Methacrylsäurehalogenids oder Mischungen dieser mit oxalkyliertem Trimethylolpropan, vorzugsweise in Gegenwart eines basischen Hilfsmittels wie z.B. tert. Amine, nach den üblichen Methoden der organischen Chemie erhalten.

Die Umsetzung des oxalkylierten Trimethylolpropans mit Acrylsäure oder Methacrylsäure oder Mischungen dieser zum ethylenisch ungesättigten OH-gruppenhaltigen Partialester erfolgt vorzugsweise durch säurekatalysierte Veresterung in Gegenwart eines Schleppmittels und den üblichen Polymerisationsinhibitoren. Diese Verfahren sind Stand der Technik.

Besonders gute Ergebnisse werden erzielt, wenn als Komponente B das Reaktionsprodukt von 2 Mol Acrylsäure und 1 Mol eines oxethylierten Trimethylolpropans (OH-Zahl um 550, Oxethylierungsgrad ca. 4) verwandt wird.

Als Komponente C kommen Hydroxyalkylacrylate mit 2–6, insbesondere 2 C-Atomen in der Alkylgruppe in Frage. Namentlich seien genannt: 2-Hydroxyethyl-, 2-Hydroxypropyl-, 2-Hydroxybutyl-, 3-Hydroxypropyl-, 4-Hydroxybutyl- und 6-Hydroxyhexylacrylat, sowie die entsprechenden Methacrylate. Bevorzugt werden 2-Hydroxyethylacrylat, 2-Hydroxypropylacrylat und 4-Hydroxybutylacrylat, insbesondere 2-Hydroxyethylacrylat.

Das erfindungsgemässe Bindemittel wird durch Umsetzung von 1 Grammäquivalent NCO eines Polyisocyanates (Komponente A), 0,4–1,2, vorzugsweise 0,5–1,1 Grammäquivalenten OH eines OH-gruppenhaltigen ethylenisch ungesättigten Partialesters (Komponente B) und 0–0,6, vorzugsweise 0–0,5 Grammäquivalenten OH eines Hydroxyalkylacrylates (Komponente C) erhalten, wobei die Summe der Hydroxyläquivalente aus B und C 1–1,2, vorzugsweise 1–1,1 beträgt. Durch Variation des Verhältnisses der Komponente B zur Komponente C lassen sich die Eigenschaften des erfindungsgemässen Bindemittels in weiten Grenzen beeinflussen.

Die Umsetzung des Polyisocyanats mit den OH-haltigen ethylenisch ungesättigten Partialestern und den Hydroxyalkylacrylaten kann bei Temperaturen von 20°C bis 90°C, vorzugsweise bei 40°C bis 70°C in einem Eintopfverfahren oder in mehreren Stufen durchgeführt werden. Bei einem mehrstufigen Verfahren ist die Umsetzung des Polyisocyanats mit dem Hydroxyalkylacrylat in der ersten Stufe, gefolgt von der Addition des Hydroxylgruppen-haltigen ethylenisch ungesättigten Partialesters in der zweiten Stufe, bevorzugt.

Die Urethanbildungsreaktion kann in an sich bekannter Weise z.B. mit Zinnoctoat, Dibutylzinndilaurat oder tertiären Aminen katalysiert werden. Ebenso kann das Urethanacrylat durch Zugabe geeigneter Inhibitoren und Antioxydantien je 0,001–0,3 Gew.-%, bezogen auf Gesamtmischung, vor vorzeitiger und unerwünschter Polymerisation geschützt werden. Diese Polymerisationsinhibitoren werden auch zur Erzielung einer hohen Dunkellagerstabilität zweckmässigerweise eingesetzt.

Geeignete Hilfsmittel dieser Art sind beispielsweise Phenole und Phenolderivate, vorzugsweise sterisch gehinderte Phenole, die in beiden o-Stellungen zur phenolischen Hydroxygruppe Alkylsubstituenten mit 1-6 C-Atomen enthalten, Amine, vorzugsweise sekundäre Acrylamine und ihre Derivate, Chinone, Kupfer-I-Salz organischer Säuren oder Anlagerungsverbindungen von Kupfer(I)halogeniden an Phosphite.

Namentlich seien genannt: 4,4'-Bis-(2,6-di-tert.-butylphenol), 1,3, 5-Trimethyl-2,4,6-tris-(3,5-di-tert.-butyl-4-hydroxy-benzyl)-benzol, 4,4'-Butyliden-bis-(6-tert.-butyl-m-kresol), 3,5-Di-tert.-butyl-4-hydroxybenzyl-phosphonsäurediethylester, N,N'-Bis-(β-naphthyl)-p-phenylen-diamin, N,N'-Bis-(1-methylheptyl)-p-phenylen-diamin, Phenyl-β-naphthylamin, 4,4'-Bis-(α,α-dimethylbenzyl)-diphenylamin, 1,3, 5-Tris-(3,5-di-tert.-butyl-4-hydroxy-hydrocinnamoyl)-hexahydro-s-triazin, Hydrochinon, p-Benzochinon, 2,5-Di-tert.-butylchinon, Toluhydrochinon, p-tert.-Butylbenzcatechin, 3-Methylbrenzcatechin, 4-Ethylbrenzcatechin, Chloranil, Naphthochinon, Kupfer-naphthenat, Kupferoctoat, Cu(I)Cl/Triphenylphosphit, Cu(I)Cl/Trimethylphosphit, Cu(I)Cl/Trischlorethyl-phosphit, Cu(I)Cl/Tripropylphosphit, p-Nitrosodimethylanilin.

Weitere geeignete Stabilisatoren sind in «Methoden der organischen Chemie» (Houben-Weyl), 4. Auflage, Band XIV/1, Seite 433-452, 756, Georg Thieme Verlag, Stuttgart, 1961, beschrieben. Sehr gut geeignet ist z.B. p-Benzochinon und/oder Hydrochinonmonomethylether in einer Konzentration von 0,001 bis 0,3 Gew.-%, bezogen auf Gesamtmischung.

Die erfindungsgemässen Umsetzungsprodukte können ohne zusätzlich copolymerisierbare Monomere oder Lösungsmittel zur Anwendung gelangen, da es sich im allgemeinen um niedrig viskose Produkte handelt.

In den Fällen, in denen eine Abmischung mit copolymerisierbaren Monomeren gewünscht ist, ist dies selbstverständlich möglich. Zur Abmischung geeignete copolymerisierbare Monomere sind:

1. Ester der Acryl- oder Methacrylsäure mit aliphatischen $C_1$-$C_8$, cycloaliphatischen $C_5$-$C_6$, araliphatischen $C_7$-$C_8$ Monoalkoholen, beispielsweise Methylacrylat, Ethylacrylat, n-Propyl-acrylat, n-Butylacrylat, Methylhexylacrylat, 2-Ethylhexylacrylat und die entsprechenden Methacrylsäureester; Cyclopentylacrylat, Cyclohexylacrylat oder die entsprechenden Methacrylsäureester; Benzylacrylat, β-Phenylethylacrylat und entsprechende Methacrylsäureester;

2. Hydroxyalkylester der Acryl- oder Methacrylsäure mit 2-4 C-Atomen in der Alkoholkomponente, wie 2-Hydroxyethylacrylat, 2-Hydroxypropylacrylat, 3-Hydroxypropylacrylat, 2-Hydroxybutylacrylat, 4-Hydroxybutylacrylat oder entsprechende Methacrylsäureester;

3. Di- und Polyacrylate sowie Di- und Polymethacrylate von Glykolen mit 2 bis 6 C-Atomen und Polyolen mit 3-4 Hydroxylgruppen und 3 bis 6 C-Atomen, wie Ethylen-glykoldiacrylat, Propandiol-1,3-diacrylat, Butandiol-1,4-diacrylat, Hexandiol-1,6-diacrylat, Trimethylolpropantriacrylat, Pentaerythrittri- und -tetraacrylat sowie entsprechende Methacrylate, ferner Di(meth)-acrylate von Polyetherglykolen des Glykols, Propandiol-1,3, Butandiol-1,4, tetraoxethyliertes Trimethylolpropantrisacrylat;

4. Aromatische Vinyl und Divinylverbindungen, wie Styrol, Methylstyrol, Divinylbenzol;

5. N-Methylolacrylamid oder N-Methylolmethacrylamid sowie entsprechende N-Methylolalkylether mit 1-4 C-Atomen in der Alkylethergruppe bzw. entsprechende N-Methylolallylether, insbesondere N-Methoxymethyl(meth)acrylamid, N-Butoxymethyl(meth)acrylamid und N-Allyloxymethyl(meth)acrylamid;

6. Vinylalkylether mit 1-4 C-Atomen in der Alkylgruppe, wie Vinylmethylether, Vinylethylether, Vinylpropylether, Vinylbutylether;

7. Trimethylolpropandiallylethermono(meth)-acrylat, Vinylpyridin, N-Vinylcarbazol, Triallylphosphat, Triallylisocyanurat und andere.

Es können auch Gemische aus einem oder mehreren der vorgenannten Monomeren eingesetzt werden. Die Zusätze können etwa 0-70 Gew.-%, vorzugsweise 0-40 Gew.-% betragen, bezogen auf Mischung aus erfindungsgemässen Reaktionsprodukten und zusätzlichen Monomeren.

Gewünschtenfalls ist es ebenfalls möglich, die erfindungsgemässen Umsetzungsprodukte mit inerten Lösungsmitteln wie Butylacetat, Ethylacetat, Ethanol, Isopropanol, Butanol, Aceton, Ethylmethylketon, Diethylketon, Cyclopropanol, Butanol, Aceton, Ethylmethylketon, Diethylketon, Cyclohexan, Cyclohexanon, Cyclopentan, Cyclopentanon, n-Heptan, n-Hexan, n-Octan, Isooctan, Toluol, Xylol, Methylenchlorid, Chloroform, 1,1-Dichlorethan, 1,2-Dichlorethan, 1,1,2-trichlorethan, Tetrachlorkohlenstoff abzumischen.

Die Zusätze können etwa 0-50 Gew.-%, vorzugsweise 0-40 Gew.-%, bezogen auf Mischung aus erfindungsgemässen Reaktionsprodukten und zusätzlichen Lösungsmitteln betragen.

Natürlich ist es auch möglich, Mischungen aus zusätzlichen Monomeren und Lösungsmitteln innerhalb der angegebenen Mengenverhältnisse einzusetzen.

Weiterhin ist es ebenfalls möglich, die erfindungsgemässen Bindemittel mit Hilfe externer Emulgatoren und gegebenenfalls üblicher in der Emulsionstechnik angewandter Hilfsmittel in Wasser zu emulgieren und als Emulsionen zu applizieren.

Als Emulgatoren kommen anionische, nichtionische, kationische, ampholytische oder hochmolekulare Stoffe sowie deren Mischungen in Frage. Entsprechende Emulgatoren sind beispielsweise in Ullmanns Encyclopädie der techn. Chemie, Bd. 10, 4. Auflage, Kap. Emulsionen, S. 449 ff. beschrieben. Geeignete Emulgatoren können qualitativ und quantitativ leicht durch einfache Handversuche ermittelt werden.

Die Emulsionen können 10 bis 70 Gew.-%, vorzugsweise 30 bis 70 Gew.-%, insbesondere 40-60 Gew.-% der erfindungsgemässen Bindemittel enthalten.

Die Härtung der erfindungsgemässen Reaktionsprodukte, gegebenenfalls in Mischung mit anderen copolymerisierbaren Monomeren kann mittels energiereicher Strahlung, wie UV-Licht, Elektronen-, Gammastrahlen oder in Gegenwart von Radikale liefernden Substanzen, wie thermische Polymerisationsinitiatoren erfolgen.

Vorzugsweise werden die erfindungsgemässen Reaktionsprodukte als durch UV-Licht härtbare Überzugsmassen eingesetzt. Für diese Anwendung ist der Zusatz von Photoinitiatoren erforderlich.

Als Photoinitiatoren sind die üblicherweise eingesetzten Verbindungen geeignet, beispielsweise Benzophenon sowie ganz allgemein aromatische Ketoverbindungen, die sich vom Benzophenon ableiten, wie Alkylbenzophenone, halogenmethylierte Benzophenone, gemäss der deutschen Offenlegungsschrift 1 949 010, Michlers Keton, Anthron, halogenierte Benzophenone. Ferner eignen sich Benzoin und seine Derivate, etwa gemäss den deutschen Offenlegungsschriften 1 769 168, 1 769 853, 1 769 854, 1 807 297, 1 807 301, 1 916 678, 2 430 081 und der deutschen Auslegeschrift 1 694 149. Ebenfalls wirksame Photoinitiatoren stellen Anthrachinon und zahlreiche seiner Derivate dar, beispielsweise β-Methylanthrachinon, tert. Butylanthrachinon und Anthrachinoncarbonsäureester, ebenso Oximester gemäss der deutschen Offenlegungsschrift 1 795 089.

Die erwähnten Photoinitiatoren, die je nach Verwendungszweck der erfindungsgemässen Massen in Mengen zwischen 0,1 und 20 Gew.-%, vorzugsweise 0,1-5 Gew.-%, bezogen auf polymerisierbare Komponenten eingesetzt werden, können als einzelne Substanz oder, wegen häufiger vorteilhafter synergistischer Effekte, auch in Kombination miteinander verwendet werden.

Häufig kann es vorteilhaft sein, sei es zur Verbesserung der filmbildenden Eigenschaften der Harzmassen oder aber um eine besonders kratzfeste Oberfläche der Schichten zu erhalten, weitere Zusätze zu verwenden. So ist ein Abmischen mit anderen Harztypen, beispielsweise mit gesättigten oder ungesättigten Polyestern durchaus möglich.

Vorzugsweise werden die Harze in Mengen von 0-50 Gew.-%, bezogen auf die polymerisierbaren Komponenten, eingesetzt. Grundsätzlich jedoch sollten nur solche Harze mitverwendet und ihre Menge soweit begrenzt werden, dass eine Beeinträchtigung der Reaktivität nicht auftritt. Geeignete in der Lackindustrie gebräuchliche Lackharze sind in den Lackrohstofftabellen von E. Karsten, 5. Auflage, Curt R. Vicentz Verlag, Hannover, 1972, Seiten 74-106, 195-258, 267-293, 335-347, 357-366 beschrieben.

Vorteilhafte Zusätze, die zu einer weiteren Steigerung der Reaktivität führen können, sind bestimmte tert.-Amine wie z.B. Triethylamin und Triethanolamin.

Die genannten Stoffe werden vorzugsweise in Mengen von 0-5 Gew.-% bezogen auf die polymerisierbaren Komponenten, eingesetzt.

Als Strahlenquellen zur Durchführung der Photopolymerisation können künstliche Strahler, deren Emission im Bereich von 2500-5000 Å, vorzugsweise 3000-4000 Å liegt, verwendet werden. Vorteilhaft sind Quecksilberdampf-, Xenon- und Wolfram-Lampen, insbesondere Quecksilberhochdruckstrahler.

In der Regel lassen sich Schichten der erfindungsgemässen Reaktionsprodukte mit einer Dicke zwischen 1 μm und 0,1 mm (1 μm = $10^{-3}$ mm) in weniger als einer Sekunde zu einem Film aushärten, wenn sie mit dem Licht einer ca. 8 cm entfernten Quecksilberhochdrucklampe, beispielsweise vom Typ HTQ-7 der Firma Philips, bestrahlt werden.

Werden Füllstoffe bei der Verwendung der erfindungsgemässen Harzmassen als UV-Lichthärtende Überzüge mitverwendet, so ist deren Einsatz auf solche beschränkt, die durch ihr Absorptionsverhalten den Polymerisationsvorgang nicht unterdrücken. Beispielsweise können Talkum, Schwerspat, Kreide, Gips, Kieselsäuren, Asbestmehle und Leichtspat als lichtdurchlässige Füllstoffe verwendet werden.

Erfolgt die Härtung durch thermische Initiatoren oder durch energiereiche Strahlung, z.B. Elektronenstrahlung oder γ-Strahlung, so sind prinzipiell alle Füllstoffe, Pigmente und Verstärkungsmaterialien, wie sie in der Lackchemie üblicherweise eingesetzt werden, verwendbar.

Das Auftragen der Überzugsmittel auf geeignete Substrate kann mittels in der Lackindustrie üblichen Methoden, wie Sprühen, Walzen, Rakeln, Drucken, Tauchen, Fluten, Streichen, Pinseln, erfolgen.

Geeignete Substrate sind Papier, Kartonage, Leder, Holz, Kunststoffe, Vlies, Textilien, keramische Materialien, mineralische Materialien, Glas, Metall, Kunstleder, photographische Materialien wie z.B. mit photographischer Schicht versehenes Papier, Umkehrfilme, vorzugsweise Holz, Kunststoffe, keramische Materialien, mineralische Materialien und photographische Materialien. Da die Überzugsmittel in Sekundenbruchteilen bis zu wenigen Sekunden zu Filmen mit ausgezeichneten mechanischen Eigenschaften aushärten, ist es beispielsweise möglich, einen Beschichtungsvorgang den in der Druckbranche üblichen Verarbeitungsgeschwindigkeiten anzupassen.

Die erfindungsgemässen Reaktionsprodukte sind auch als Bindemittel für Druckfarben, zur Herstellung von Photoreliefdruckplatten bzw. Photoresistmaterialien hervorragend geeignet.

In den folgenden Beispielen seien zur Veranschaulichung der Erfindung einige typische Ausführungsformen dargelegt.

Die Viskositäten wurden entweder in 4 mm-Auslaufbecher nach DIN 53 211 (Angabe in Se-

kunden) oder mit einem Viscotester der Fa. Haake Typ VI 02V (Angabe in Poise, Messbereich bis 4000 Poise) bestimmt.

Die Jodfarbzahlen wurden nach DIN 6162 bestimmt.

Beispiel 1

Es wird ein OH-gruppenhaltiger ethylenisch ungesättigter Partialester hergestellt, indem ein oxethyliertes Trimethylolpropan [OH-Zahl 550 (mg KOH/g Substanz), Oxethylierungsgrad ca. 4] mit Acrylsäure azeotrop verestert wird.

925 g oxethyliertes Trimethylolpropan werden mit 430 g Acrylsäure, 12 g p-Toluolsulfonsäure, 1 g p-Methoxy-phenol, 1,2 g Di-tert.-butylhydrochinon und 280 g Toluol unter Durchleiten von Luft zum Rückfluss erhitzt und das entstehende Reaktionswasser azeotrop entfernt. Nach Erreichen einer Säurezahl kleiner 3 (mg KOH/g Substanz) wird das Lösungsmittel im Vakuum entfernt und das Produkt einer Klärfiltration unterworfen. Es wird ein OH-gruppenhaltiger ethylenisch ungesättigter Partialester mit folgenden Kenndaten erhalten:

| | |
|---|---|
| Viskosität: | 59 sec (22°C) |
| Jodfarbzahl: | 0–1 |
| Säurezahl: | 2 |
| OH-Zahl: | 115 |

Beispiel 2

Ein erfindungsgemässes Harz wird hergestellt durch Umsetzung des OH-gruppenhaltigen ethylenisch ungesättigten Partialesters nach Beispiel 1, Hydroxyethylacrylat und Toluylendiisocyanat.

In einer Rührapparatur werden unter Überleiten von trockener Luft 174 g 2,4-Toluylendiisocyanat und 0,3 g p-Methoxyphenol auf 40–65°C erwärmt und innerhalb von 1 Stunde 116 g Hydroxyethylacrylat unter Beibehaltung der Temperatur zugetropft. Nach Erreichen eines NCO-Wertes von 14,5 Gew.-% werden 490 g des OH-gruppenhaltigen ethylenisch ungesättigten Partialesters nach Beispiel 1 innerhalb von 1,5 Stunden zugegeben und bei einer Temperatur von 50–65°C so lange gerührt, bis der NCO-Wert kleiner 0,1 Gew.-% beträgt. Man erhält ein erfindungsgemässes Bindemittel mit den folgenden Kenndaten:
Viskosität: 550 P (55 Pas) (22°C)

Beispiel 3

Es wird ein erfindungsgemässes Harz wie in Beispiel 2 beschrieben hergestellt, mit der Änderung, dass als Diisocyanatkomponente 221 g Isophorondiisocyanat verwandt werden. Man erhält ein erfindungsgemässes Harz mit folgenden Kenndaten:
Viskosität: 510 P (51 Pas) (22°C)

Beispiel 4

Es wird ein erfindungsgemässes Harz wie in Beispiel 2 beschrieben hergestellt, mit der Änderung, dass als Diisocyanatkomponente 262 g 4,4'-Diisocyanatodicyclohexylmethan verwandt werden. Man erhält ein erfindungsgemässes Harz mit folgenden Kenndaten:
Viskosität: 850 P (85 Pas) (22°C)

Beispiel 5

Ein erfindungsgemässes Harz wird hergestellt durch Umsetzung des OH-gruppenhaltigen ethylenisch ungesättigten Partialesters nach Beispiel 1 und 2,4-Toluylendiisocyanat.

In einer Rührapparatur werden unter Überleiten von trockener Luft 174 g 2,4-Toluylendiisocyanat und 0,7 g p-Methoxyphenol vorgelegt und auf 40–65°C erwärmt. Innerhalb von ca. 2 Stunden werden 980 g des OH-gruppenhaltigen ethylenisch ungesättigten Partialesters nach Beispiel 1 zugegeben und bei der angegebenen Temperatur so lange gerührt, bis der NCO-Wert kleiner 0,1 Gew.-% beträgt. Man erhält ein erfindungsgemässes Bindemittel mit folgenden Kenndaten:
Viskosität: 400 P (40 Pas) (22°C)

Beispiel 6

Es wird ein erfindungsgemässes Harz wie in Beispiel 5 beschrieben hergestellt, mit der Änderung, dass 221 g Isophorondiisocyanat als Diisocyanatkomponente verwandt werden. Man erhält ein erfindungsgemässes Bindemittel mit folgenden Kenndaten:
Viskosität: 620 P (62 Pas) (22°C)

Beispiel 7

Es wird ein erfindungsgemässes Harz wie in Beispiel 5 beschrieben hergestellt, mit der Änderung, das 262 g 4,4'-Diisocyanatodicyclohexylmethan als Diisocyanatkomponente verwandt werden. Man erhält ein erfindungsgemässes Bindemittel mit folgenden Kenndaten:
Viskosität: 640 P (64 Pas) (22°C)

Vergleichsbeispiel 8

Es wird zu Vergleichszwecken ein Urethanacrylat hergestellt durch Umsetzung von Trimethylolpropan, Isophorondiisocyanat und Hydroxyethylacrylat.

In einer Rührapparatur werden unter Überleiten von trockener Luft 663 g Isophorondiisocyanat und 0,7 g p-Methoxyphenol vorgelegt und auf 50–65°C erwärmt. Anschliessend werden innerhalb von 2 Stunden 348 g Hydroxyethylacrylat unter Beibehaltung der Temperatur zugetropft. Nach Erreichen eines NCO-Wertes von 12,5 Gew.-% werden 134 g Trimethylolpropan zugegeben und der Ansatz so lange gerührt, bis der NCO-Wert kleiner 0,1 Gew.-% beträgt. Man erhält ein hochviskoses Harz.
Viskosität: >> 4000 P (400 Pas) (22°C)

Vergleichsbeispiel 9

Es wird zu Vergleichszwecken ein Urethanacrylat wie in Beispiel 8 beschrieben hergestellt, mit der Änderung, dass als Polyolkomponente 310 g eines oxethylierten Trimethylolpropans (OH-Zahl 550) eingesetzt werden. Man erhält ein hochviskoses Harz.

Viskosität: >> 4000 P (22°C)

Vergleichsbeispiel 10

Es wird zu Vergleichszwecken ein Urethanacrylat wie in Beispiel 8 beschrieben hergestellt, mit der Änderung, dass als Polyolkomponente 680 g eines oxethylierten Trimethylolpropans (OH-Zahl 250) eingesetzt werden. Man erhält ein hochviskoses Harz.
Viskosität: >> 4000 P (22°C)

Anwendungsbeispiel A

Es werden jeweils 75 g der Bindemittel nach den Beispielen 2 bis 7 und den Vergleichsbeispielen 8 bis 10 mit 50 g eines tetraoxethylierten Trimethylolpropantrisacrylat (gemäss Vergleichsbeispiel 13), 2,5 g Benzildimethylketal, 10 g Benzophenon, 10 g Triethanolamin und den in Tabelle 1 angegebenen Mengen Hexandiolbisacrylat versetzt, so dass ein 50 sec. Lack (DIN 53 211, 4 mm-Auslaufbecher) erhalten wird.

Tabelle 1

| Harz nach | g Hexandiol-bisacrylat | Formulie-rung |
|---|---|---|
| Beispiel 2 | 55 | A |
| Beispiel 3 | 60 | B |
| Beispiel 4 | 65 | C |
| Beispiel 5 | 55 | D |
| Beispiel 6 | 60 | E |
| Beispiel 7 | 65 | F |
| Vergleichsbeispiel 8 | 140 | G |
| Vergleichsbeispiel 9 | 133 | H |
| Vergleichsbeispiel 10 | 130 | I |

Die so erhaltenen Formulierungen A bis I werden jeweils mit einem drahtumwickelten Metallstab auf eine bedruckte Kartonage zu einem 8 μm dicken Film ausgezogen. Anschliessend werden die Beschichtungen auf einem Transportband mit regelbarer Bandgeschwindigkeit unter einem Hanovia-Strahler (80 W/cm, Abstand 8 cm) zu klebfreien Überzügen gehärtet, die lösungsmittel- und kratzfest sind. Ergebnisse siehe Tabelle 2.

Tabelle 2

| Harz nach | Formulierung | Reaktivität (m/min) |
|---|---|---|
| Beispiel 2 | A | 25 |
| Beispiel 3 | B | 25 |
| Beispiel 4 | C | 25 |
| Beispiel 5 | D | 25 |
| Beispiel 6 | E | 25 |
| Beispiel 7 | F | 25 |
| Vergleichsbeispiel 8 | G | 15–20 |
| Vergleichsbeispiel 9 | H | 15–20 |
| Vergleichsbeispiel 10 | I | 15 |

Die Tabelle 3 zeigt deutlich, dass die erfindungsgemässen Bindemittel 2 bis 7 einen erheblich geringeren Monomerenbedarf (Menge Hexandiolbisacrylat in Gramm) zur Einstellung der Verarbeitungsviskosität aufweisen. Die Abprüfung der in der Tabelle 1 aufgelisteten Formulierungen A-F, die mit dem erfindungsgemässen Bindemittel nach den Beispielen 2 bis 7 erstellt wurden, zeigt, dass diese Formulierungen eine ausgezeichnete Reaktivität in Gegenwart von Luftsauerstoff aufweisen (Tabelle 2). Die auf bedruckter Kartonage erhaltenen gehärteten Überzüge haben eine gute Haftung, sind lösungsmittel- und kratzfest und zeigen bei Knickversuchen um 180°C keine Rissbildung an der Knickkante.

Vergleichsbeispiel 11

Zu Vergleichszwecken wird ein Harz durch Umsetzung von 522 g 2,4-Toluylendiisocyanat, 348 g Hydroxyethylacrylat und 980 g eines oxalkylierten Trimethylolpropans (OH-Zahl 174, 50% Ethylenoxid, 50% Propylenoxid) hergestellt, wie es in Vergleichsbeispiel 8 beschrieben ist. Man erhält ein hochviskoses Harz.
Viskosität: >4000 P (22°C)

Anwendungsbeispiel B

Es werden jeweils 50 Teile der Massen nach Beispiel 2 und 5 sowie des Vergleichsbeispiels 11 mit 1,5 g Benzildimethylketal versetzt und mit einem Rakel zu einem 150 μm dicken Film auf einer Glasplatte ausgezogen. Anschliessend werden die Filme auf einem Transportband mit regelbarer Bandgeschwindigkeit unter einem Hanovia-Strahler (80 W/cm, Abstand 8 cm) zu klebfreien Überzügen der Reaktivität und die Abprüfung der gehärteten Filme finden sich in Tabelle 3.

Tabelle 3

| Harz nach | UÄ | Reaktivität m/min | Vickers-Härte | Pendel-härte |
|---|---|---|---|---|
| Beispiel 2 | 390 | 30 | 13,0 | 158 sec. |
| Beispiel 5 | 577 | 30–35 | 6,9 | 64 sec. |
| Vergleichs-beispiel 11 | 306 | 15–20 | 0,5 | 21 sec. |

UÄ = Urethanbindungsäquivalenz
    (Gramm Substanz pro Urethanbildung)
Pendelhärte nach König (DIN 53 157)
Vickers-Härte nach ASTM D 1417–57T.

Die Tabelle 3 zeigt, dass die erfindungsgemässen Bindemittel nach den Beispielen 2 und 5 bei gleichem Diisocyanat und im Falle von Beispiel 2 bei vergleichbarer Urethanbindungsäquivalenz wie im Vergleichsbeispiel 11 deutlich höhere Reaktivitäten in Gegenwart von Luftsauerstoff und deutlich bessere Filmeigenschaften aufweisen, als dies bei dem Bindemittel des Vergleichsbeispiels 11 der Fall ist. Auch die Filme des Bindemittels nach Beispiel 5 zeigen wesentlich bessere Eigenschaften, obwohl hier die Urethanbindungsäquivalenz deutlich geringer als im Vergleichsbeispiel 11 ist.

Vergleichsbeispiel 12

Zu Vergleichszwecken wird ein Harz durch Umsetzung von 174 g 2,4-Toluylendiisocyanat und 232 g Hydroxyethylacrylat analog zu Beispiel 2 hergestellt. Man erhält ein hochviskoses, teils wachsartig erstarrtes Harz.

Vergleichsbeispiel 13

Zu Vergleichszwecken wird ein oxethyliertes Trimethylolpropan-trisacrylat (oxethyliertes Trimethylolpropan: OH-Zahl 550), hergestellt, wobei wie in Beispiel 1 beschrieben verfahren wird, mit der Änderung, das 648 g Acrylsäure verwandt werden. Man erhält eine niedrig viskose Flüssigkeit.
Viskosität: 35 sec. (20°C)

Anwendungsbeispiel C

Es wird wie in Anwendungsbeispiel B verfahren, mit der Änderung, dass die Massen nach den Vergleichsbeispielen 12 und 13 verwandt werden. Ergebnisse der Reaktivität und der Filmabprüfung sind in Tabelle 4 tabelliert.

Tabelle 4

| Harz nach | DBÄ | Reaktivität m/min | Filmeigenschaften |
|---|---|---|---|
| Beispiel 2 | 260 | 30 | hart, aber elastisch |
| Beispiel 5 | 288 | 30–35 | hart, aber elastisch |
| Vergleichsbeispiel 12 | 203 | 30–35 | glashart, spröde, Film nicht elastisch |
| Vergleichsbeispiel 13 | 157 | +) | – |

DBÄ = Doppelbindungsäquivalent (Anzahl der Doppelbindungen pro Gramm Substanz)
+) trotz extrem langer Belichtungszeit konnte keine Härtung erreicht werden

Die Auswertung der Tabelle 4 zeigt, dass die urethangruppenhaltigen Bindemittel nach den Beispielen 2 und 5 und dem Vergleichsbeispiel 12 eine ausgezeichnete Reaktivität im Vergleich zum urethangruppenfreien Acrylat des Vergleichsbeispiels 13 aufweisen. Die Ergebnisse der Tabelle 4 zeigen aber auch, dass die erfindungsgemässen Massen nach den Beispielen 2 und 5 Überzüge mit ausgezeichneten Lackqualitäten ergeben, im Gegensatz zu den Massen der Vergleichsbeispiele 12 und 13.

Vergleichsbeispiel 14

Zu Vergleichszwecken wird ein urethangruppenhaltiges Bindemittel, wie in Beispiel 3 beschrieben, hergestellt, mit der Änderung, dass 340 g eines OH-Gruppen-haltigen Partialesters, der als Umsetzungsprodukt von 2 Mol Acrylsäure und 1 Mol eines oxethylierten Trimethylolpropans (OH-Zahl 750, Oxethylierungsgrad ca. 2) analog zu Beispiel 1 hergestellt, eingesetzt werden.
Viskosität: 980 P (98 Pas) (22°C)

Vergleichsbeispiel 15

Zu Vergleichszwecken wird ein urethangruppenhaltiges Bindemittel, wie in Beispiel 5 beschrieben, hergestellt, mit der Änderung, dass 680 g des in Vergleichsbeispiel 14 beschriebenen ungesättigten Partialesters eingesetzt werden.
Viskosität: 880 P (88 Pas) (22°C)

Anwendungsbeispiel D

Zur Prüfung der Lagerstabilität werden jeweils 100 g der erfindungsgemässen Bindemittel nach Beispiel 3 und 5 und den Vergleichsbeispielen 14 und 15 ohne und mit Photoinitiator (2,5 g 1-(4-Isopropylphenyl)-2-hydroxy-2-methylpropan-1-on) im Dunkeln bei 60°C und Raumtemperatur gelagert.
Ergebnisse siehe Tabelle 5.

Tabelle 5

| Harz nach | Initiator | Lagerstabilität 60°C | Raumtemperatur |
|---|---|---|---|
| Beispiel 3 | × | >10 Tage | > 3 Monate |
| Beispiel 5 | × | >10 Tage | > 3 Monate |
| Beispiel 3 | | >10 Tage | > 3 Monate |
| Beispiel 5 | | >10 Tage | > 3 Monate |
| Vergleichsbeispiel 14 | × | 5 Tage | 7 Tage |
| Vergleichsbeispiel 15 | × | 2 Tage | 4 Tage |
| Vergleichsbeispiel 14 | | 4 Tage | 15 Tage |
| Vergleichsbeispiel 15 | | 1 Tage | 8 Tage |

Vergleichsbeispiel 16

Zu Vergleichszwecken wird ein urethangruppenhaltiges Bindemittel, wie in Beispiel 3 beschrieben, hergestellt, mit der Änderung, dass 590 g eines OH-Gruppen-haltigen Partialesters, der als Umsetzungsprodukt von 2 Mol Acrylsäure und 1 Mol eines oxethylierten Trimethylolpropans (OH-Zahl 305, Oxethylierungsgrad ca. 7), analog zu Beispiel 1 hergestellt, eingesetzt wird,
Viskosität: 480 P (48 Pas) (22°C)

Vergleichsbeispiel 17

Zu Vergleichszwecken wird ein urethangruppenhaltiges Bindemittel, wie in Beispiel 5 beschrieben, hergestellt, mit der Änderung, dass 1180 g des in Vergleichsbeispiel 16 beschriebenen Partialesters eingesetzt werden,
Viskosität: 380 P (38 Pas) (22°C)

Anwendungsbeispiel E

Es werden jeweils 100 g der erfindungsgemässen Bindemittel nach den Beispielen 2 bis 7 und den Vergleichsbeispielen 16 bis 17 mit 2,5 g 2-Hydroxy-2-methyl-1-phenylpropan-1-on versetzt. Anschliessend werden von jeder Harzformulierung auf einer Mahagoniholzplatte mit einem Rakel 50 µm dicke Filme gezogen und auf einem Transportband mit einer Bandgeschwindigkeit von 10 m/min unter einem Hanovia-Strahler (80 W/cm, Abstand 8 cm) gehärtet. Die so hergestellten Beschichtungen werden auf Lösungsmittelfestigkeit geprüft; indem ein mit Lösungsmittel getränkter, feuchter Wattebausch 60 Minuten unter leichtem Druck auf die Beschichtungen gelegt wird.

Ergebnisse siehe Tabelle 6.

### Tabelle 6

| Harz nach | Wasser | Ethanol | Ethanol/ Wasser 1:1 | Aceton |
|---|---|---|---|---|
| Beispiel 2 | o.B. | o.B. | o.B. | o.B. |
| Beispiel 3 | o.B. | o.B. | o.B. | o.B. |
| Beispiel 4 | o.B. | o.B. | o.B. | o.B. |
| Beispiel 5 | o.B. | o.B. | o.B. | o.B. |
| Beispiel 6 | o.B. | o.B. | o.B. | o.B. |
| Beispiel 7 | o.B. | o.B. | o.B. | o.B. |
| Vergleichsbeispiel 16 | o.B. | Fl. | Fl. | Fl. |
| Vergleichsbeispiel 17 | o.B. | Fl. | Aqu. | Aqu. |

o.b. = ohne Befund
Fl. = Fleckenbildung
Aqu. = Angequollen

### Anwendungsbeispiel F

Es wird eine wässrige Emulsion hergestellt, indem jeweils 100 g der erfindungsgemässen Bindemittel nach den Beispielen 2 bis 7 mit jeweils 3 g Benzildimethylketal vermischt werden und zu dieser mit einem Ultraschnellrührer gerührten Mischung portionsweise eine Lösung von 100 g Wasser und 2 g eines geradkettigen $C_{10}$–$C_{18}$-Alkylbenzolsulfonats sowie 3 g eines Polyvinylalkohols (MG ca. 80 000) gegeben werden. Die erhaltenen Emulsionen werden anschliessend mit einem Rakel zu 150 µm dicken Filmen auf Mahagoniholz ausgezogen. Zum Ablüften des Wassers wurden die Beschichtungen für 8 Minuten in einem auf 80°C erwärmten Luftstrom belassen. Die entwässerten Überzüge zeigten eine gute Verfilmung. Zur Härtung wurden die Proben auf einem Transportband mit regelbarer Bandgeschwindigkeit bei 15 m/min unter einem Hanovia-Strahler (80 W/cm. Abstand 8 cm) bestrahlt. Die erhaltenen, gehärteten Überzüge waren lösungsmittel- und kratzfest und erfüllten die an einen gehärteten Lack zu stellenden Qualitätsansprüche.

### Patentansprüche

1. Strahlenhärtbare Bindemittel aus Umsetzungsprodukten von Polyisocyanaten mit ethylenisch ungesättigten hydroxylgruppenhaltigen Partialestern und Hydroxyalkylacrylaten, dadurch gekennzeichnet, dass das Umsetzungsprodukt aus in das oligomere Bindemittel eingebauten Einheiten von

A) 1 Grammäquivalent NCO eines Polyisocyanats mit 2-3 Isocyanatgruppen pro Molekül

B) 0,4-1,2 Grammäquivalenten OH eines ethylenisch ungesättigten Partialesters mit einer OH-Zahl von 80 bis 150 aus einem oxalkylierten Trimethylolpropan mit einem Oxalkylierungsgrad von 3 bis 4,5 und Acrylsäure oder Methacrylsäure oder deren Mischung

C) 0-0,6 Grammäquivalenten OH eines Hydroxyalkylacrylates oder Hydroxyalkylmethacrylates oder deren Mischung mit 2-6 C-Atomen in der Alkylgruppe besteht, wobei die Summe der OH-Grammäquivalente aus B und C 1-1,2 beträgt.

2. Strahlenhärtbare Bindemittel nach Anspruch 1, dadurch gekennzeichnet, dass das Polyisocyanat Toluylendiisocyanat, Isophorondiisocyanat, 4,4′-Diisocyanatodicyclohexylmethan oder Hexamethylendiisocyanat ist.

3. Strahlenhärtbare Bindemittel nach Anspruch 1, dadurch gekennzeichnet, dass das oxalkylierte Trimethylolpropan im Anlagerungsprodukt aus Trimethylolpropan und Ethylenoxid, Propylenoxid oder Butylenoxid oder deren Mischungen besteht.

4. Strahlenhärtbare Bindemittel nach Anspruch 1, dadurch gekennzeichnet, dass als Komponente B ein ethylenisch ungesättigter Partialester mit einer OH-Zahl von 80 bis 150 eingesetzt wird, welcher durch Umsetzung von 1 Mol eines oxethylierten Trimethylolpropans mit einer OH-Zahl um 550 und 2 Mol Acrylsäure erhalten wird.

5. Verwendung der Bindemittel gemäss Anspruch 1 bis 4, in 20-70 gew.-%igen wässrigen Dispersionen zur Imprägnierung, Beschichtung, Verfestigung oder Grundierung von textilen Materialien, Holz, Kunststoffen, Vlies oder Leder.

6. Verfahren zur Herstellung von strahlenhärtbaren Bindemitteln aus Umsetzungsprodukten von Polyisocyanaten mit ethylenisch ungesättigten hydroxylgruppenhaltigen Partialestern und Hydroxyalkylacrylaten, dadurch gekennzeichnet, dass man

A) 1 Grammäquivalent NCO eines Polyisocyanats mit 2-3 Isocyanatgruppen pro Molekül,

B) 0,4-1,2 Grammäquivalenten OH eines ethylenisch ungesättigten Partialesters mit einer OH-Zahl von 80 bis 150 aus einem oxalkylierten Trimethylolpropan mit einem Oxalkylierungsgrad von 3 bis 4,5 und Acrylsäure oder Methacrylsäure oder deren Mischung,

C) 0-0,6 Grammäquivalenten OH eines Hydroxyalkylacrylates oder Hydroxyalkylmethacrylates oder deren Mischung mit 2-6 C-Atomen in der Alkylgruppe im Eintopfverfahren oder in mehreren Stufen reagieren lässt, wobei die Summe der OH-Grammäquivalente aus (B) und (C) 1-1,2 beträgt, und wobei man beim mehrstufigen Verfahren bevorzugt in der ersten Stufe Komponente (A) mit Komponente (C) und in der zweiten Stufe das Reaktionsprodukt von (A) und (C) mit Komponente (B) umsetzt.

## Claims

1. Radiation-hardenable binders comprising reaction products of polyisocyanates with ethylenically unsaturated partial esters containing hydroxyl groups and hydroxyalkyl acrylates, characterised in that the reaction product consists of units, incorporated into the oligomeric binder, of
A) 1 NCO gram equivalent of a polyisocyanate containing 2–3 isocyanate groups per molecule,
B) 0.4–1.2 OH gram equivalents of an ethylenically unsaturated partial ester, having an OH number of 80 to 150, of an alkoxylated trimethylol propane having a degree of alkoxylation of 3 to 4.5 and acrylic acid or methacrylic acid or a mixture thereof, and
C) 0–0.6 OH gram equivalents of a hydroxyalkyl acrylate or hydroxyalkyl methacrylate or a mixture thereof containing 2–6 C atoms in the alkyl group, the sum of the OH gram equivalents of B and C being 1–1.2.

2. Radiation-hardenable binders according to Claim 1, characterised in that the polyisocyanate is toluylene diisocyanate, isophorone diisocyanate, 4,4′-diisocyanato-dicyclohexylmethane or hexamethylene diisocyanate.

3. Radiation-hardenable binders according to Claim 1, characterised in that the alkoxylated trimethylol propane in the addition product consists of trimethylol propane and ethylene oxide, propylene oxide or butylene oxide or mixtures thereof.

4. Radiation-hardenable binders according to Claim 1, characterised in that as component B an ethylenically unsaturated partial ester having an OH number of 80 to 150 is used, which is obtained by reacting 1 mole of an ethoxylated trimethylol propane having an OH number of about 550 with 2 moles of acrylic acid.

5. Use of the binders according to Claim 1 to 4 in 20–70% strength by weight aqueous dispersions for impregnating, coating, reinforcing or priming textile materials, wood, plastics, nonwovens or leather.

6. Process for the production of radiation-hardenable binders from reaction products of polyisocyanates with ethylenically unsaturated partial esters containing hydroxyl groups and hydroxyalkyl acrylates, characterised in that
A) 1 NCO gram equivalent of a polyisocyanate containing 2–3 isocyanate groups per molecule,
B) 0.4–1.2 OH gram equivalents of an ethylenically unsaturated partial ester, having an OH number of 80 to 150, of an alkoxylated trimethylol propane having a degree of alkoxylation of 3 to 4.5 and acrylic acid or methacrylic acid or a mixture thereof, and
C) 0–0.6 OH gram equivalents of a hydroxyalkyl acrylate or hydroxyalkyl methacrylate or a mixture thereof containing 2–6 C atoms in the alkyl group are allowed to react in a one-pot process or in several stages, the sum of the OH gram equivalents of (B) and (C) being 1–1.2, and wherein in the case of a multistage process it is preferred to react component (A) with component (C) in the first stage and to react the reaction product of (A) and (C) with component (B) in the second stage.

## Revendications

1. Liants durcissables par irradiation formés de produits de réaction de polyisocyanates avec des esters partiels à insaturation éthylénique contenant des groupes hydroxyle et d'acrylates d'hydroxyalkyle, caractérisés en ce que le produit de réaction est formé de motifs, incorporés au liant oligomère, de
A) 1 gramme-équivalent de NCO d'un polyisocyanate ayant 2–3 groupes isocyanato par molécule
B) 0,4–1,2 gramme-équivalent de OH d'un ester partiel à insaturation éthylénique, à indice d'hydroxyle de 80 à 150, d'un triméthylolpropane oxalkylé à degré d'oxalkylation de 3 à 4, 5 et d'acide acrylique ou d'acide méthacrylique ou de leur mélange
C) 0–0,6 gramme-équivalent de OH d'un alkylate d'hydroxyalkyle ou d'un méthacrylate d'hydroxyalkyle ou de leur mélange ayant 2 à 6 atomes de carbone dans le groupe alkyle, la somme des grammes-équivalents de OH de B et C s'élevant à 1–1,2.

2. Liants durcissables par irradiation suivant la revendication 1, caractérisés en ce que le polyisocyanate est un diisocyanatotoluène, l'isophoronediisocyanate, le 4,4′-diisocyanatodicyclohexylméthane ou l'hexaméthylènediisocyanate.

3. Liants durcissables par irradiation suivant la revendication 1, caractérisés en ce que le triméthylolpropane oxalkylé dans le produit d'addition est formé de triméthylolpropane et . d'oxyde d'éthylène, d'oxyde de propylène ou d'oxyde de butylène ou de leurs mélanges.

4. Liants durcissables par irradiation suivant la revendication 1, caractérisés en ce qu'on utilise comme composant B un ester partiel à insaturation éthylénique ayant un indice d'hydroxyle de 80 à 150, qui est obtenu par réaction d'une mole d'un triméthylol-propane oxéthylé ayant un indice d'hydroxyle de l'ordre de 550 et de 2 moles d'acide acrylique.

5. Utilisation des liants suivant les revendications 1 à 4 en dispersions aqueuses à 20–70% en poids pour l'imprégnation, le couchage, le renforcement ou l'apprêtage de matières textiles, de bois, de matières plastiques, d'un non-tissé ou de cuir.

6. Procédé de production de liants durcissables par irradiation formés de produits de réaction de polyisocyanates avec des esters partiels à insaturation éthylénique renfermant des groupes hydroxyle et d'acrylates d'hydroxyalkyle, caractérisé en ce qu'on fait réagir
A) 1 gramme-équivalent de NCO d'un polyisocyanate porteur de 2–3 groupes isocyanato par molécule,
B) 0,4–1,2 gramme-équivalent de OH d'un ester partiel à insaturation éthylénique d'indice d'hydroxyle allant de 80 à 150 obtenu à partir d'un triméthylolpropane oxalkylé et de degré d'oxalky- lation égal à 3–4,5 et d'acide acrylique ou d'acid méthacrylique ou de leur mélange,

C) 0–0,6 gramme-équivalent de OH d'un acrylate ou ou d'un méthacrylate d'hydroxyalkyle ou de leur mélange, ayant 2 à 6 atomes de carbone dans le groupe alkyle, par le procédé en un seul récipient ou en plusieurs étapes, la somme des grammes-équivalents de OH de (B) et (C) s'élevant à 1–1,2, et lorsqu'on opère selon le procédé en plusieurs étapes, on fait réagir de préférence dans la première étape le composant (A) avec le composant (C) et dans la seconde étape le produit de réaction de (A) et (C) avec le composant (B).